Europäisches Patentamt

European Patent Office

Office européen des brevets

(11) Veröffentlichungsnummer: **0 162 315**
**B1**

(12) **EUROPÄISCHE PATENTSCHRIFT**

(45) Veröffentlichungstag der Patentschrift:
06.12.89

(21) Anmeldenummer: 85104926.2

(22) Anmeldetag: 23.04.85

(51) Int. Cl.⁴: **H 03 M 1/46,** H 03 M 1/18

(54) **Analog-Digital-Wandler.**

(30) Priorität: 15.05.84 CH 2379/84

(43) Veröffentlichungstag der Anmeldung:
27.11.85 Patentblatt 85/48

(45) Bekanntmachung des Hinweises auf die Patenterteilung:
06.12.89 Patentblatt 89/49

(84) Benannte Vertragsstaaten:
CH DE FR GB LI SE

(56) Entgegenhaltungen:
FR-A-2 443 174
US-A-3 972 626

RADIO FERNSEHEN ELEKTRONIK, Band 32, Heft 11,
November 1983, Seiten 705-706, Ost-Berlin, DD; K.H.
KURSAWE: "Wertebereichserweiterung eines
8-bit-ADU"

(73) Patentinhaber: BBC Brown Boveri AG,
Haselstrasse, CH- 5401 Baden (CH)

(72) Erfinder: Maschek, Martin, Juchstrasse 4, CH- 8116
Würenlos (CH)
Erfinder: Mastner, Georg, Dr., Loonstrasse 5, CH-
5443 Niederrohrdorf (CH)

**Beschreibung**

Die Erfindung bezieht sich auf einen Analog-Digital-Wandler gemäss dem Oberbegriff des Anspruchs 1.

Mit diesem Oberbegriff nimmt die Erfindung auf einen Stand der Technik Bezug, wie er beispielsweise aus der US-Patentschrift US-A-4 296 412 bekannt ist.

Insbesondere für elektronische Stromwandler werden A/D-Wandler benötigt die neben kurzem "data-refresh" zum Erreichen von kleinen Phasenfehlern auch eine sehr breite Dynamik erfordern. Bei einem kombinierten Wandler für Mess- und Schutzzwecke kann eine Dynamik von bis 20 Bit benötigt werden.

Der schnelle "data-refresh" kann mit einem Nachlauf nach der eingangs genannten US-Patentschrift oder auch nach einer Schaltungsanordnung erreicht werden, wie sie in der europäischen Patentanmeldung EP-A1-0 158 841 der Anmelderin, veröffentlicht am 23.10.85, beschrieben und dargestellt ist. Dieses Dokument fällt unter Artikel 54 (3) EPÜ.

Die Dynamik des Analog-Digital-Wandlers nach US-A-4 296 412 ist durch die Stellenzahl am Ausgang des digitalen Integrators bzw. am Eingang des zur Rückkopplung verwendeten Digital-Analog-Wandlers einerseits und durch die Anforderungen an die Genauigkeit der Umsetzung des Eingangssignals andererseits beschränkt, auch wenn besagte Anforderungen nur für einen Teil des vom Eingangssignal überstrichenen Bereichs gelten.

Es ist ferner vorgeschlagen worden, die Dynamik eines Nachlauf-A/D-Wandlers durch Anwendung von mehreren Nachlaufschleifen beliebig zu erweitern. Diese Methode hat allerdings den Nachteil, dass sich in dem ganzen A/D-Wandler einige analoge Komponenten, wie z. B. D/A-Wandler und Spannungskomparatoren (bzw. ganze Sätze von Fensterdiskriminatoren, da vorzugsweise Nachlaufschleifen mit erhöhter Folgegeschwindigkeit benutzt werden), mehrmals wiederholen.

Die vorliegende Erfindung setzt sich zum Ziel, eine Vereinfachung des Nachlauf A/D-Wandlers mit beliebig erweiterbarer Dynamik zu erreichen, die sich kostengünstig auswirkt und durch Anwendung von kleinerer Anzahl analoger Komponenten auch bessere MTBF-Werte (mean time between failure) erreicht, also betriebssicherer ist.

Der Erfindung liegt dabei die folgende Idee zugrunde: Ein normaler Nachlauf-A/D-Wandler besteht aus einem Skalierungsverstärker für das Eingangssignal, einem D/A-Wandler, einem digitalen Integrator, einem Mehrfach-Fenster-Diskriminator (z. B. nach der genannten EP-A1-0 158 841), einem Clock-Generator und aus Mitteln zum Vergleichen des Momentanwertes des skalierten Signales mit dem Ausgangssignal des D/A-Wandlers.

Zur Erweiterung der Dynamik über die Bitzahl des D/A-Wandlers wird nun erfindungsgemäss vorgeschlagen, den gattungsgemässen Nachlauf-A/D-Wandler um einen Skalierungsverstärker mit umschaltbarer Verstärkung, um einen digitalen Multiplizierer des im Integrator gespeicherten Wertes, um Mittel zum Umspeichern des multiplizierten Ausgangswertes des Integrators zurück in den Integrator und um einen digitalen, vorzugsweise vom Ausgang des Integrators gesteuerten, Bereich-Umschalter/Speicher ("range-selector") zu ergänzen.

Die durch die Erfindung erreichten Vorteile liegen vor allem darin, dass sie eine nahezu beliebige Vergrösserung der Dynamik gegenüber bekannten gattungsgemässen Analog–Digital–Wandler ermöglicht, ohne dass dafür, solange sich das Eingangssignal in einem Bereich bewegt, in dem es der Verarbeitung durch einen vergleichbaren bekannten gattungsgemässen Analog-Digital-Wandler zugänglich wäre, demselben gegenüber eine verringerte Genauigkeit der Umsetzung in Kauf genommen werden müsste. Ein wichtiger Vorteil liegt ferner im ausserordentlich schnellen "data-refresh", der unter normalen Betriebsbedingungen nur eine Taktperiode in Anspruch nimmt.

Die Umsetzung des Eingangssignals passt sich derart an die Grösse des letzteren an, dass der Quantisierungsfehler in einer festen Relation zur jeweils vom Eingangssignal erreichten Grössenordnung steht. Diese Eigenschaft des erfindungsgemässen Analog-Digital-Wandler macht denselben sehr geeignet zur Verarbeitung des Ausgangssignals eines Strom- oder Spannungswandlers, vor allem, wenn derselbe zugleich Mess- und Schutzzwecken dient, da nicht nur das ungestörte Signal, das innerhalb eines begrenzten Bereichs bleibt, mit hoher, für Messzwecke ausreichender Genauigkeit umgesetzt werden kann, sondern auch Störungen grosser Amplitude, wie sie z. B. bei Kurzschlüssen auftreten, für Schutzzwecke hinreichend genau erfasst werden können.

Erfindungsgemässe Analog-Digital-Wandler können schaltungstechnisch sehr einfach und kostengünstig realisiert werden. Im folgenden wird die Erfindung anhand von Zeichnungen, welche nur ein Ausführungsbeispiel darstellen, und von einigen Diagrammen näher erläutert.

In der Zeichnung zeigt:

Fig. 1    das Blockschema eines Nachlauf-Analog-Digital-Wandlers mit erweiterter Dynamik, anhand dessen die Erfindung erläutert werden soll,

Fig. 2    eine schematische Darstellung eines digitalen Integrators mit einem mal-1/4 Multiplizierer,

Fig. 3    ein gegenüber Fig. 1 detailliertes Blockschaltbild eines Ausführungsbeispiels der Erfindung,

Fig. 4    ein Ausführungsbeispiel eines Mehrfach-Fensterdiskriminators, wie er in der Schaltungsanordnung nach Fig. 3 eingesetzt wird,

Fig. 5 ein Ausführungsbeispiel für den digitalen Integrator mit kaskadierten Vorwärts-Rückwärtszählern samt zugehöriger Steuerlogik für den A/D-Wandler,

Fig. 6 einige Diagramme des zeitlichen Verlaufs des Eingangssignals und die zeitlichen Verläufe einiger im Analog-Digital-Wandler gemäss Fig. 3 bei der Umsetzung desselben auftretender Signale.

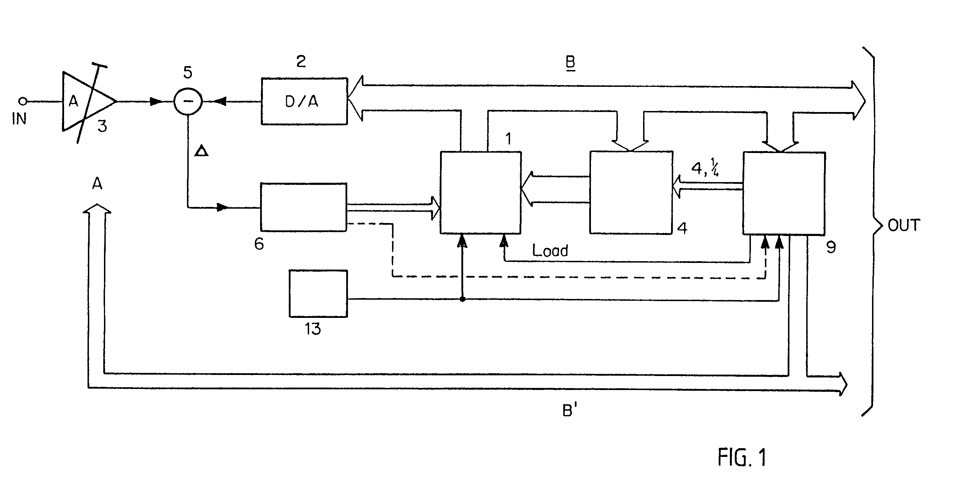

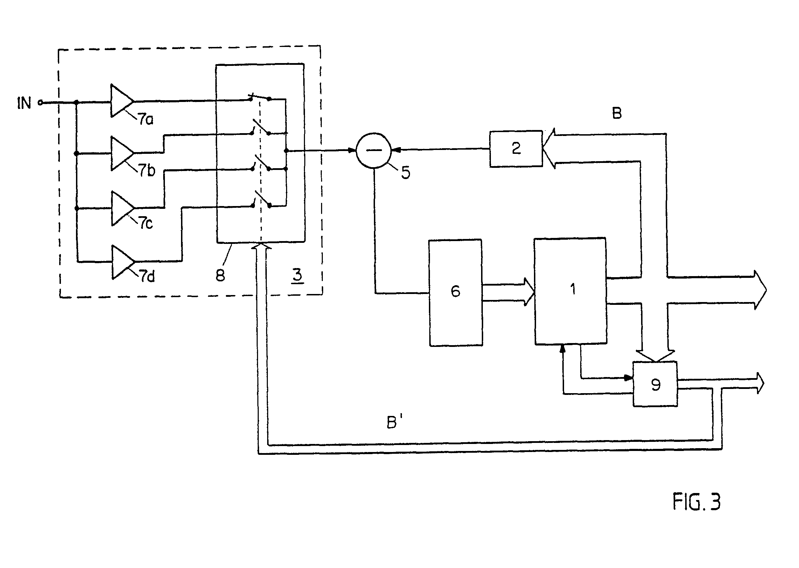

Im Blockschaltbild nach Fig. 1 ist mit 1 ein digitaler Integrator mit 12-Bit-Ausgang bezeichnet, der an einem 12 Bit breiten Bus B angeschlossen ist. An den Bus B ist ferner ein 12-Bit Digital-Analog-Wandler (D/A-Wandler) 2 geführt. Das Eingangssignal E des Analog-Digital-Wandlers wird an den Eingang IN einer Schaltung zur Skalierung des Eingangssignals angeschlossen, deren Verstärkungsfaktor A einstellbar ist. Es wird in diesem Beispiel eine Skalierungsverstärkeranordnung mit umschaltbarer Verstärkung A = 1, 1/4, 1/16, 1/64 angenommen (vgl. Fig. 3). Die Ausgänge der Skalierungsverstärkeranordnung 3 und des D/A-Wandlers führen an ein Subtrahierglied 5, welches aus den genannten Ausgangssignalen ein Differenzsignal Δ bildet. Dieses gelangt über eine Nachführschaltung ("increment quantizer") 6 zum digitalen Integrator 1. An den Bus B ist ferner ein digitaler Multiplizierer 4 angeschlossen, der ausgelegt ist für eine von einer als Bereichsumschalter dienenden Steuerlogik 9 gesteuerten Multiplikation der Ausgangsdaten des digitalen Integrators 1 mit den Faktoren 4 oder 1/4 wahlweise. Der Satz der Ausgangsdaten aus Ausgang OUT besteht aus dem 12 Bit Ausgang des Integrators 1 (11 Bit und Vorzeichen) und einem digitalen Ausgang der Steuerlogik 9, der als Multiplikationsfaktor (z. B. in kodierter Form als Angabe der binären Potenz) für die 12 Bit dient. Über den Bus B' ist letzterer an die Skalierungsverstärkeranordnung 3 geführt und bewirkt dort die Umschaltung des Verstärkungafaktors A. Die Steuerlogik 9 und der digitale Integrator 1 werden von einem zentralen Taktgenerator 13 zeitlich gesteuert.

Bei kleinem Eingangssignal ist zunächst der Verstärkungsfaktor 1 eingeschaltet, die Nachlaufschleife arbeitet auf die bekannte Art. Überschreitet infolge des Ansteigens des skalierten Eingangssignales der momentane Zustand des Integrators 1 einen vorgewählten Absolutwert (z. B. zwischen 7/8 und 8/8 eines "full-scale's"), schaltet die Steuerlogik 9 automatisch die Verstärkung der Skalierungsverstärkeranordnung 3 auf 1/4. Zugleich werden die mit dem Faktor 1/4 multiplizierten Ausgangsdaten des Integrators 1 durch einen Ladebefehl zurück in den Integrator 1 geladen, so dass auch der analoge Ausgangswert des D/A-Wandlers 2 durch den gleichen Faktor 4 dividiert wird. Nach dem Abklingen der Umschalttransienten ("settling-time") der Skalierungsverstärkeranordnung und des D/A-Wandlers 2 wird innerhalb einer Takt-Periode am Eingang der "Nachführschaltung 6" wieder Gleichgewicht erreicht. Da gleichzeitig mit dem Umladen des Integrators 1 auch die neue Bereichinformation an den Ausgang der Steuerlogik 9 gelegt wird, ist der Wert des digitalen Ausgangs-Daten-Satzes (Bereich-Multiplikationsfaktor mal Ausgangsdaten des Integrators) auch während der Bereichsumschaltung stetig.

Sinngemäss geschieht Buch die automatische Umschaltung in die höheren Bereiche (1/16 und 1/64).

Sinkt die Signalamplitude wieder, schaltet der Bereichumschalter bei einem vorgewählten Wert des skalierten Eingangssignales in den nächst tieferen, empfindlicheren Bereich. Dabei wird der mit einem Faktor 4 multiplizierte Ausgangswert des Integrators durch den "load" Befehl in den Integrator geladen, so dass wieder ein Gleichgewicht der Analogwerte erreicht wird. Zugleich ändert wieder auch der digitale Multiplikationsfaktor im Ausgangsdaten-Satz, so dass der digitale Wert wieder stetig bleibt.

Da alle Bereichumschaltungen innerhalb einer Takt-Periode geschehen, bleibt der "data-refresh" unverändert.

Die Umschaltung in einen empfindlicheren (tieferen) Signalbereich kann vorzugsweise beim Erreichen des Wertes Null erfolgen, wo auf eine Multiplikation mit dem Faktor 4 verzichtet werden kann. Dadurch kann auch die logische Schaltung wesentlich vereinfacht werden.

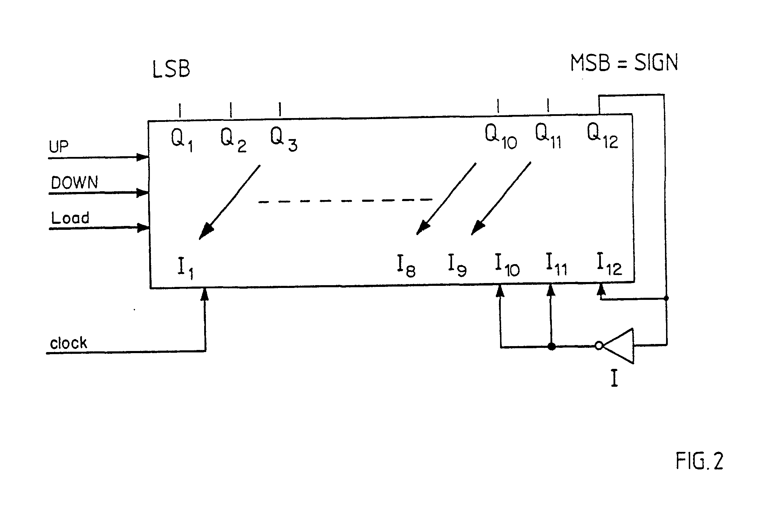

Fig. 2 zeigt schematisch ein Ausführungsbeispiel eines 12-Bit-Integrators mit einem mal 1/4 Multiplizierer. Der Integrator ist aufgebaut als dreistufige Kaskade von Vorwärts-Rückwärts-Zählern, z. B. 74LS169. Die Ausgänge $Q_3$ bis $Q_{11}$ werden - jeweils um 2 Bit nach unten versetzt - mit den parallelen Dateneingängen $I_1$ bis $I_9$ verbunden. Das höchstwertige Bit (MSB-Bit) bleibt unverändert und wird weiter über einen Inverter I den Dateneingängen $I_{10}$ und $I_{11}$ zugeführt. Zur Multiplikation mit dem Faktor 1/4 werden mit einem clock-synchronen "load" Befehl die verschobenen Daten (durch 4 dividierter Zustand des Integrators) in den Zähler zurück geladen.

Während die vorstehenden Darlegungen das Ziel verfolgten, die prinzipielle Wirkungsweise der Erfindung beispielhaft zu verdeutlichen, wird nachstehend anhand eines detaillierteren Ausführungsbeispiels eine bevorzugte Ausführungsform des erfindungsgemässen Analog-Digital-Wandlers im Aufbau und Funktion erläutert.

Der in den Figuren 3 bis 5 dargestellte Analog-Digital-Wandler weist einen digitalen Integrator 1 mit 12-Bit-Ausgang auf, einen demselben nachgeschalteten Digital-Analog-Wandler 2, eine Eingangsverstärkeranordnung 3 zur Skalierung des Eingangssignals E, deren Eingang mit der Eingangsklemme IN des Analog-Digital-Wandlers verbunden ist, ein Subtrahierglied 5, welches aus dem Ausgangssignal des Eingangsverstärkers 3 und demjenigen des Digital-AnalogWandlers 2 ein Differenzsignal bildet, sowie eine Nachführschaltung 6, der das Differenzsignal zugeführt wird und welche aufgrund desselben Nachführsignale erzeugt, welche dem Integrator 1 zugeleitet werden.

Die Eingangsverstärkeranordnung 3 umfasst vier Verstärker 7a, 7b, 7c und 7d mit festen Verstärkungsfaktoren A = 1, 1/4, 1/16 bzw. 1/64. Den Verstärkern nachgeschaltet ist ein Wahlschalter 8, welcher jeweils den Ausgang eines derselben an den Ausgang des Eingangsverstärkers 3 legt. Gesteuert wird der Wahlschalter 8 von einer Steuerlogik 9, welche bei Überschreiten der oberen oder unteren Grenze des Arbeitsbereichs des Integrators 1 gegebenenfalls eine Umschaltung des Wahlschalters 8 auf den nächsten Verstärker bewirkt sowie gleichzeitig eine Veränderung des Wertes des digitalen Ausgangssignals des Integrators 1, welche einer Division desselben durch 4 unter Vernachlässigung des Rests entspricht. Die Steuerlogik 9 zeigt ausserdem den jeweils gültigen Verstärkungsfaktor an.

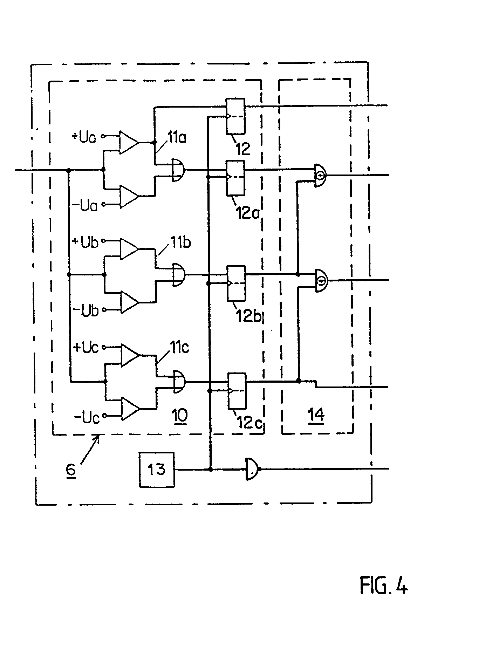

Die Nachführschaltung 6 (Fig. 4) enthält einen MehrfachFensterdiskriminator 10 mit einem ersten Diskriminator 11a, welcher feststellt, ob der Betrag des Differenzsignals einen ersten Grenzwert $U_a$ überschreitet und wenn ja, welche Polarität es hat, sowie mit einem zweiten Diskriminator 7b und einem dritten Diskriminator 7c, welche das Differenzsignal daraufhin überprüfen, ob sein Betrag einen zweiten Grenzwert $U_b$ bzw. einen dritten Grenzwert $U_c$ überschreitet. Der erste Grenzwert $U_a$ ist etwas grösser als die Hälfte der einem niedrigstwertigen Bit entsprechenden Spannung, d.h. der Spannung, welche am Ausgang des Digital-Analog-Wandlers 2 erscheint, wenn dem Eingang desselben nur ein niedrigstwertiges Bit zugeführt wird, der zweite Grenzwert $U_b$ etwa 10 Mal so gross wie besagte Spannung, also etwas grösser als die Hälfte der einem Bit der Wertigkeit $2^4$ entsprechenden Spannung und der dritte Grenzwert $U_c$ ist etwa 150 Mal so gross wie die einem niedrigstwertigen Bit entsprechende Spannung, also etwas grösser als die Hälfte der einem Bit mit Wertigkeit $2^8$ entsprechenden Spannung. Den Diskriminatoren 11a, b, c sind D-Flipflops 12, 12a, b, c nachgeschaltet, welche bei positiven Flanken eines von einem Taktgenerator 13 gelieferten Taktsignals die jeweiligen Ausgangssignale der Diskriminatoren 11a, b, c speichern. Flipflop 12 speichert das Polaritätssignal, Flipflops 12a, b, c die Betragssignale.

Dem Mehrfach-Fensterdiskriminator 10 nachgeschaltet ist eine Logikschaltung 14, welche bei Auftreten mehrerer positiver Betragssignale jeweils nur das dem höchsten Betrag entsprechende positive Betragssignal weiterleitet.

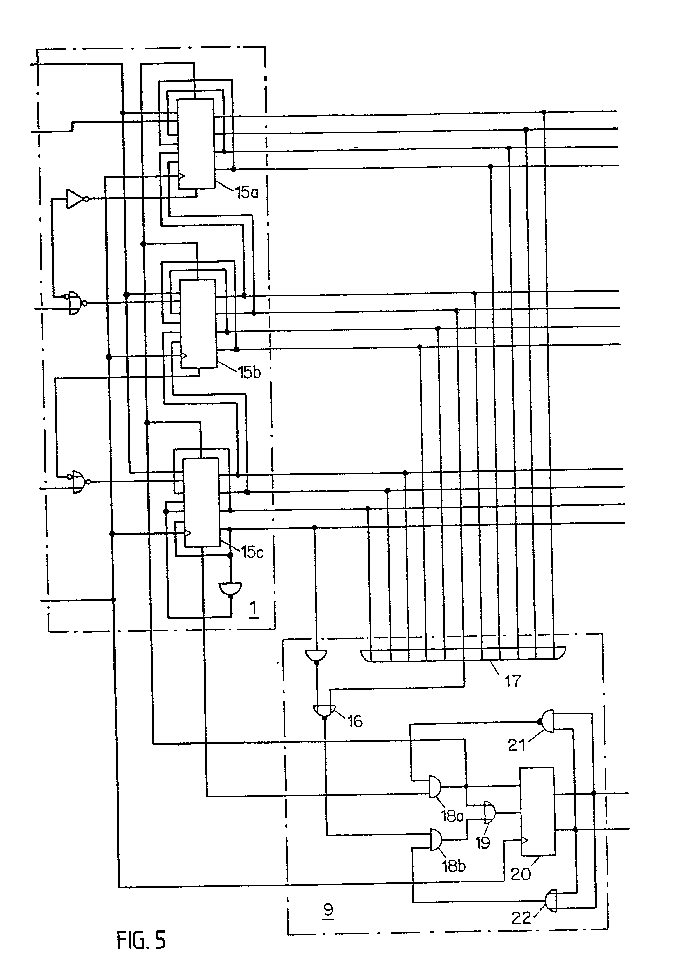

Der Integrator 1 - Fig. 5 zeigt eine konkrete Realisierungist als dreistufige Kaskade von setzbaren 4-Bit-Vorwärts-Rückwärts-Zählern (z. B. SN 54 LS 669) 15a, b, c ausgebildet. An den Zählrichtungseingängen der Zähler 15a, b, c liegt jeweils das von der Nachführschaltung 6 gelieferte Polaritätssignal, an den Zähleingang des ersten Zählers 15a wird das dem niedrigsten Betrag entsprechende Betragssignal, an denjenigen des zweiten Zählers 15b das dem mittleren und an denjenigen des dritten Zählers 15c das dem höchsten Betrag entsprechende Betragssignal geleitet. Positive Betragssignale bewirken also - je nach dem Wert des Polaritätssignals - Additionen von Bits der Wertigkeit $2^0$, $2^4$ bzw. $2^8$ zum Ausgangssignal des Integrators 1 oder Subtraktionen von demselben, entsprechend den Beträgen $U_a$, $U_b$, $U_c$ der Grenzwerte, mit denen das Differenzsignal in den Diskriminatoren 11a, b, c verglichen wird. Die Zähler 15a, b, c werden von den positiven Flanken des invertierten Taktsignals gesteuert.

Die Ausgänge des Integrators 1, an denen die Bits der Wertigkeiten $2^2$ bis $2^{10}$ erscheinen, sind jeweils mit dem Setzeingang für das Bit mit um 2 geringerem Stellenwert verbunden, der Ausgang, an dem das Bit mit Wertigkeit $2^2$ erscheint, mit dem Setzeingang für das niedrigstwertige Bit usw. Das Bit mit der Wertigkeit $2^{11}$, das auch die Polarität anzeigt - analog Null entspricht einem Ausgangssignal des Integrators 1, bei welchem das Bit der Wertigkeit $2^{11}$ "1" ist und alle übrigen "0" - wird unmittelbar an den ihm selber zugeordneten Setzeingang und invertiert an die Setzeingänge für die Bits der Wertigkeiten $2^9$ und $2^{10}$ geführt. Jeder der Zähler 15a, b, c weist einen Eingang für Setzbefehle auf.

Die Steuerlogik 9 weist ein NOR-Gatter 16 auf, dem einerseits invertiert das Bit der Wertigkeit $2^{11}$ und andererseits das Ausgangssignal eines ODER-Gatters 17, das die Bits der Wertigkeiten $2^0$ bis $2^{10}$ verknüpft, zugeführt wird. Während an ein erstes UND-Gatter 18a das Überlaufsignal des dritten Zählers 15c des Integrators 1 geleitet wird, gelangt das Ausgangssignal des NOR-Gatters 16 an ein zweites UND-Gatter 18b. Die Ausgänge der UND-Gatter 18a und 18b werden, durch ein ODER-Gatter 19 verknüpft, an den Zähleingang eines Vorwärts-Rückwärts-Zählers 20 geleitet, an dessen Zählrichtungseingang jeweils das Ausgangssignal des ersten UND-Gatters 18a liegt und der vom gleichen Taktsignal gesteuert wird wie die Zähler 15a, b, c des Integrators 1. Die beiden am Ausgang des Zählers liegenden digitalen Signale werden einerseits, durch ein NAND-Gatter 21 verknüpft, an das erste UND-Gatter 18a, andererseits, durch ein ODER-Gatter 22 verknüpft, an das zweite UND-Gatter 18b geführt. Ausserdem bilden sie das digitale Ausgangssignal der Steuerlogik 9, das den Eingangsverstärker 3 steuert und den jeweiligen Skalierungsfaktor desselben anzeigt.

Der Ausgang des ersten UND-Gatters 18a ist mit den Eingängen für Setzbefehle der Zähler 15a, b, c des Integrators 1 verbunden.

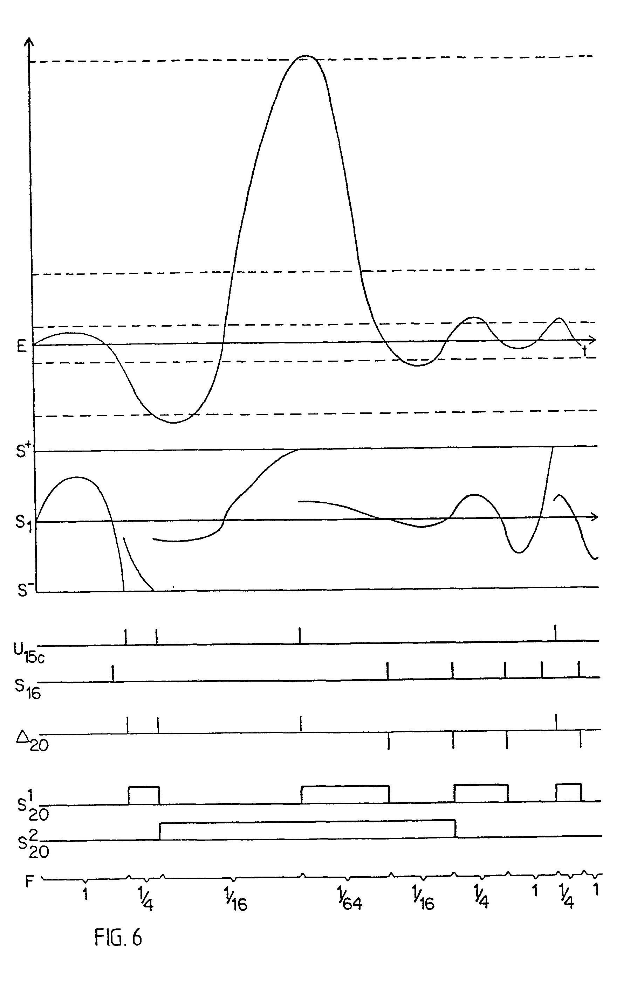

Im folgenden wird unter Zuhilfenahme von Fig. 6 die Funktion des Analog-Digital-Wandlers gemäss Fig. 3 bis 5 näher erläutert.

In Fig. 6 oben ist ein beispielsweiser zeitlicher Verlauf eines bei Null beginnenden Eingangssignals E dargestellt, darunter das Ausgangssignal $S_1$ des digitalen Integrators 1 in analoger Darstellung.

Als Anfangszustand sei angenommen dass die beiden bereichbestimmenden Ausgänge $S_{20}^1$ und $S_{20}^2$ der Steuerlogik "0" sind und das Ausgangssignal der Schaltung zur Skalierung des Eingangssignals 3 - nun identisch mit dem Ausgangssignal des Verstärkers 7a - viel kleiner als "full-scale" des D/A-Wandlers 2 ist.

Den Änderungen des analogen Eingangssignals folgt der digitale Integrator 1, indem derselbe die von der Nachführschaltung 6 generierte Vorwärts- oder Rückwärtszählbefehle an einem von den drei Vorwärts-Rückwärts-Zählern 15a, b, c ausführt. Liegt am dritten 4-Bit Vorwärts-Rückwärts-Zähler 15c ein Vorwärtszählbefehl beim Zustand "1111" oder ein Rückwärtszählbefehl beim Zustand "0000", generiert dieser ein Überlaufsignal, welches den Nachführschritt verhindert und stattdessen eine schnelle Bereichsumschaltung initialisiert.

Das Überlaufsignal $U_{15c}$ gelangt an das erste UND-Gatter 18a und wird, da das Ausgangssignal des NAND-Gatters 21 "1" ist, einerseits an den Zählrichtungseingang des Zählers 20, andererseits über das ODER-Gatter 19 an den Zähleingang des letzteren geleitet und bewirkt daher ein Vorwärtszählen desselben, dargestellt im Diagramm $\Delta_{20}$ das erste Ausgangssignal $S_{20}^1$ des Zählers 20 von "0" auf "1", was erstens eine Umschaltung des Wahlschalters 8, der nun das Ausgangssignal des zweiten Verstärkers 7b an den Ausgang des Eingangsverstärkers 3 legt, bewirkt und andererseits anzeigt, dass der gültige Verstärkungsfaktor sich vom Verstärkungsfaktor des ersten Verstärkers 7a um einen Proportionalitätsfaktor F = 1/4 unterscheidet. Dem Subtrahierglied 5 wird also von da an und bis auf weiteres ein um einen Faktor F = 1/4 kleineres Signal zugeführt. Zugleich wird das durch das erste UND-Gatter 18a geleitete Überlaufsignal $U_{15c}$ als Setzbefehl an die entsprechenden Eingänge der Zähler 15a, b, c geleitet. Es bewirkt, dass die Bits mit den Wertigkeiten $2^9$ und $2^{10}$ ihren Zustand wechseln und die Bits mit den Wertigkeiten $2^0$ bis $2^8$ jeweils den vorherigen Zustand des um ein Faktor 4 höherwertigeren Bits übernehmen, was einer Division des Ausgangswertes des Integrators 1 durch 4 entspricht.

Da die von der Nachführschaltung 6 veranlassten Nachführschritte nun aufgrund eines mit einem um 1/4 kleineren Faktor skalierten Signals erzeugt werden, ergibt sich gegenüber dem Eingangssignal E eine Vergrösserung der Nachführschritte um einen Faktor 4. Die Relation zwischen der Grössenordnung des Eingangssignale E und der Folgegeschwindigkeit des Ausgangssignals des Analog-Digital-Wandlers bleibt also ungefähr konstant.

Erreicht der dritte Vorwärts-Rückwärts-Zähler 15c trotz der Verkleinerung des Skalierungsfaktors um ein Faktor 4 erneut einen seiner "full-scales" (Zustände "1111" oder "0000"), so generiert dieser bei entsprechendem Zählbefehl wiederum ein Überlaufsignal $U_{15c}$, welches die nächste Bereichsumschaltung initialisiert.

Der Zähler 20 erhöht seinen Zustand um 1, an den Ausgang der Schaltung zur Skalierung des Eingangssignals 3 wird das Ausgangssignal des Verstärkers 7c gelegt und der Ausgangswert des Integrators 1 wird wiederum durch 4 dividiert. Der Proportionalitätsfaktor F beträgt nun 1/16.

Auf gleiche Weise kann noch eine weitere Umschaltung durchgeführt werden. Ist der kleinste Verstärkungsfaktor wirksam - der Proportionalitätsfaktor F gegenüber dem grössten Verstärkungsfaktor beträgt dann 1/64 - so sind beide Ausgangssignale $S_{20}^1$, $S_{20}^2$ des Zählers 20 "1", das NAND-Gatter 21 produziert ein "0"-Signal und das erste UND-Gatter 18a sperrt daher eventuelle weitere Überlaufsignale $U_{15c}$ des dritten Zählers 15c.

Wenn das Ausgangssignal $S_1$ des Integrators 1 durch Null geht - das Bit der Wertigkeit $2^{11}$ hat dann den Wert "1", die übrigen Bits den Wert "0" - so ist das Ausgangssignal $S_{16}$ des NOR-Gatters 16 ein "1"-Signal, das, wenn nicht bereits der grösste Verstärkungsfaktor wirksam ist und dementsprechend beide Ausgangssignale $S_{20}^1$, $S_{20}^2$ des Integrators 1 "0" sind und damit auch das Ausgangssignal des ODER-Gatters 22, über das zweite UND-Gatter 18b und das ODER-Gatter 19 an den Zähleingang des Zählers 20 gelangt. Da das gleichzeitig am Zählrichtungseingang liegende Signal "0" ist, erfolgt ein Rückwärtszählschritt des Zählers 20, der eine Umschaltung des Eingangsverstärkers 3 auf den jeweils nächstgrösseren Verstärkungsfaktor bewirkt. Da die Umschaltung im Nulldurchgang erfolgt, ist eine entsprechende Umstellung des Ausgangssignals $S_1$ des Integrators 1 nicht erforderlich.

Die Umschaltung kann - wie beim zweiten Nulldurchgang des Ausgangssignals $S_1$ des Integrators 1 dargestellt - auch unterbleiben, und zwar dann, wenn das Null entsprechende Ausgangssignal des Integrators 1 durch ein an denselben gelangendes Zählsignal höherer Wertigkeit übersprungen wird. Dieser Effekt ist jedoch durchaus erwünscht, da beim Auftreten derartiger Zählsignale ein Abnehmen der Grössenordnung der Extrema des Eingangssignals E noch nicht zu erwarten ist.

## Patentansprüche

1. Analog-Digital-Wandler mit einem digitalen Integrator (1), einem Digital-Analog-Wandler (2), dem das Ausgangssignal des digitalen Integrators (1) zugeführt wird, einer Eingangsverstärkeranordnung (3)) der das analoge Eingangssignal zugeführt wird, einem Subtrahierglied (5), das aus dem Ausgangssignal der Eingangsverstärkeranordnung (3) und dem Ausgangssignal des Digital-Analog-Wandlers (2) ein Differenzsignal bildet, sowie einer Nachführscaltung (6)) welche in Abhängigkeit vom Differenzsignal Nachführsignale für den digitalen Integrator (1) erzeugt, dadurch gekennzeichnet, dass der Verstärkungsfaktor (A) der Eingangsverstärkeranordnung (3) in Abhängigkeit vom Ausgangswert des digitalen Integrators (1) gesteuert ist, dass mit dem digitalen Integrator (1) ein Multiplizierer (4) in Wirkverbindung steht, dessen Ausgangswert in Abhängigkeit vom aktuellen Verstärkungsfaktor (A) ein Umspeichern des multiplizierten Ausgangswertes des digitalen Integrators (1) zurück in den digitalen Integrator (1) bewirkt, und dass eine vom Ausgang des digitalen Integrators (1) gesteuerte Steuerlogik (9) zur Bereichsumschaltung und Speicherung eines ersten Ausgangsbitmusters, welches den aktuellen Verstärkungsfaktor repräsentiert, vorgesehen ist, wobei letzteres zusammen mit dem Ausgangswert des digitalen Integrators (1) den anderen Teil des Ausgangsbitmusters bildet, wobei beide Bitmuster zusammen den digitalisierten Messwert bilden.

2. Analog-Digital-Wandler nach Anspruch 1, dadurch gekennzeichnet, dass die Eingangsverstärkeranordnung zwischen einem ersten und mindestens einem weiteren Verstärkungsfaktor (A) umschaltbar ist, wobei der oder die weiteren Verstärkungsfaktoren kleiner sind als der erste Verstärkungsfaktor, dass die Steuerlogik (9) derart ausgebildet ist, dass wenn der Ausgangswert des digitalen Integrators (1) einen positiven Schwellwert ($S^+$) überschreitet oder einen negativen Grenzwert ($S^-$) unterschreitet) eine Umschaltung auf einen kleineren Verstärkungsfaktor bewirkt, und gleichzeitig eine Multiplikation des Ausgangswertes des digitalen Integrators (1) mit einem Faktor erfolgt, welcher dem Quotienten (9) aus dem aktuellen Verstärkungsfaktor, auf welchen gerade umgeschaltet wird, und dem zuvor gültigen Verstärkungsfaktor entspricht, und die Steuerlogik (9) eine erneute Umschaltung des Eingangswertes zurück auf einen grösseren Verstärkungsfaktor bewirkt, wenn diese Umschaltung zu einem Ausgangswert des digitalen Integrators (1) führt, der zwischen den genannten Schwellwerten ($S^+$, $S^-$) zu liegen kommt.

3. Analog-Digital-Wandler nach Anspruch 1 oder 2, dadurch gekennzeichnet, dass die Steuerlogik (9) dann, wenn der Ausgangswert ($S_1$) des digitalen Integrators (1) den Wert Null anzeigt eine Umschaltung auf einen grösseren Verstärkungsfaktor bewirkt.

4. Analog-Digital-Wandler nach Anspruch 1, 2 oder 3, dadurch gekennzeichnet, dass verschiedene Verstärkungsfaktoren sich jeweils um einen Faktor unterscheiden, welcher eine ganzzahlige Potenz von zwei ist.

5. Analog-Digital-Wandler nach Anspruch 4, dadurch gekennzeichnet, dass der digitale Integrator (1) als setzbarer Vorwärts-Rückwärts-Zähler ausgebildet ist und dass zwecks Umstellungen von dessen Ausgangssignal ($S_1$) bei Umschaltungen von einem Verstärkungsfaktor auf einen anderen, der sich von jenem um einen Faktor $2^{-n}$ unterscheidet, jedes Bit ausser dem höchstwertigen vom Ausgang des digitalen Integrators (1) gegebenenfalls an einen Setzeingang zum Setzen eines anderen Bits, dessen Wertigkeit sich jeweils von der des ersteren um einen Faktor $2^{-n}$ unterscheidet, geführt ist.

6. Analog-Digital-Wandler nach einem der Ansprüche 1 bis 5, dadurch gekennzeichnet, dass dessen Nachführschaltung (6) einen Mehrfach-Fensterdiskriminator (10) enthält mit

- einem ersten Diskriminator (11)) der das Differenzsignal mit einem positiven ersten oberen Grenzwert ($U_a$) und einem negativen ersten unteren Grenzwert (-$U_a$) vergleicht, deren Absolutwerte zwischen Null und der einem niedrigstwertigen Bit am Ausgang des digitalen Integrators (1) entsprechenden Analogsignalgrösse am Ausgang des Digital-Analog-Wandlers (2) liegt, und
- bei Überschreiten des ersten oberen Grenzwerts ($U_a$) und bei Unterschreiten des ersten unteren Grenzwerts (-$U_a$) jeweils ein entsprechendes Nachführungssignal zur Erhöhung bzw. Erniedrigung der am Ausgang des digitalen Integrators (1) liegenden Zahl um ein erstes Inkrement, welches den Wert des niedrigstwertigen Bits hat, erzeugt, dass der Differenzdiskriminator (10)
- mindestens einen weiteren Diskriminator (11b, 11c) enthält, welcher das Differenzsignal mit einem weiteren oberen Grenzwert ($U_b$; $U_c$) und mit einem weiteren unteren Grenzwert (-$U_b$; -$U_c$) vergleicht, und
- bei Überschreiten des weiteren oberen Grenzwerts ($U_b$; $U_c$) und bei Unterschreiten des weiteren unteren Grenzwerts (-$U_b$; -$U_c$) jeweils ein entsprechendes Nachführsignal zur Erhöhung bzw. Erniedrigung der am Ausgang des digitalen Integrators (1) liegenden Zahl um ein weiteres Inkrement erzeugt, wobei

- das weitere Inkrement jeweils grösser ist als das vorausgehende,
- die Absolutwerte der Grenzwerte ($U_b$, -$U_b$; $U_c$, -$U_c$ eines weiteren Diskriminators (7b, 7c) jeweils zwischen der des voraufgehenden Inkrements entsprechenden Analogsignalgrösse und der dem weiteren Inkrement entsprechenden Analogsignalgrösse liegt, und
- dem Differenzdiskriminator (10) eine Logikschaltung (13) nachgeschaltet ist, welche jeweils nur das der höchsten Nachführungszahl entsprechende der vom Differenzdiskriminator (10) erzeugten Nachführsignale durchlässt.

7. Analog-Digital-Wandler nach Anspruch 6, dadurch gekennzeichnet, dass sich ein Inkrement vom vorausgehenden jeweils um einen Faktor unterscheidet, der eine ganzzahlige Potenz von zwei ist.

**Claims**

1. Analog/digital converter comprising a digital integrator (1), a digital/analog converter (2) which is supplied with the output signal of the digital integrator (1), an input amplifier arrangement (3) which is supplied by the analog input signal, a subtracter (5) which forms a difference signal from the output signal of the input amplifier arrangement (3) and the output signal of the digital/analog converter (2), and a tracking circuit (6) which generates tracking signals for the digital integrator (1) as a function of the difference signal, characterised in that the gain factor (A) of the input amplifier arrangement (3) is controlled as a function of the output value of the digital integrator (1), that the digital integrator (1) is effectively connected to a multiplier (4) the output value of which effects as a function of the current gain factor (A), a restoring of the multiplied output value of the digital integrator (1) back into the digital integrator (1), and that a control logic (9) controlled by the output of the digital integrator (1) is provided for range switching and storing a first output bit pattern which represents the current gain factor, in which arrangement the latter, together with the output value of the digital integrator (1), forms the other part of the output bit pattern, both bit patterns together forming the digitised measured value.

2. Analog/digital converter according to Claim 1, characterised in that the input amplifier arrangement can be switched between a first and at least one further gain factor (A), the further gain factor or factors being smaller than the first gain factor, and that the control logic (9) is constructed in such a manner that, when the output value of the digital integrator (1) exceeds a positive threshold value ($S^+$) or drops below a negative limit value ($S^-$), a switching to a smaller gain factor is effected and simultaneously the output value of the digital integrator (1) is multiplied by a factor which corresponds to the quotient (9) of the current gain factor to which the logic is just switching and the previously valid gain factor, and the control logic (9) effects a new switching of the input value back to a larger gain factor if this switching leads to an output value of the digital integrator (1) which comes to lie between the said threshold values ($S^+$, $S^-$).

3. Analog/digital converter according to Claim 1 or 2, characterised in that the control logic (9) effects a switching to a larger gain factor when the output value ($S_1$) of the digital integrator (1) indicates the value zero.

4. Analog/digital converter according to Claim 1, 2 or 3, characterised in that various gain factors differ in each case by a factor which is an integral power of two.

5. Analog/digital converter according to Claim 4, characterised in that the digital integrator (1) is constructed as a set table up/down counter and that, for the purpose of resettings of its output signal ($S_1$) during switching operations from one gain factor to another which differs from the former by a factor of $2^{-n}$ each bit, apart from the most significant bit, if necessary, is fed from the output of the digital integrator (1) to a set input for setting another bit the significance of which differs in each case from that of the first bit by a factor of $2^{-n}$.

6. Analog/digital converter according to one of Claims 1 to 5, characterised in that its tracking circuit (6) contains a multiple window discriminator (10) comprising

– a first discriminator (11) which compares the difference signal with a positive first upper limit value ($U_a$) and a negative first lower limit value ($-U_a$) the absolute values of which lie between zero and the amplitude, corresponding to a least-significant bit at the output of the digital integrator (1), of the analog signal at the output of the digital/analog converter (2), and
– if the first upper limit value ($U_a$) is exceeded and the signal drops below the first lower limit value ($-U_a$) in each case generates a corresponding tracking signal for incrementing or decrementing the number present at the output of the digital integrator (1) by a first increment which has the value of the least significant bit, in that the difference discriminator (10)
– contains at least one further discriminator (11b, 11c) which compares the difference signal with a further upper limit value ($U_b$; $U_c$) and with a further lower limit value ($-U_b$; $U_c$), and
– if the further upper limit value ($U_b$; $U_c$) is exceeded and if the signal drops below the further lower limit value ($-U_b$; $-U_c$), generates in each case a corresponding tracking signal for incrementing or decrementing the number present at the output of the digital integrator (1) by a further increment,
in which arrangement

– the further increment is in, each case larger than the preceding one
– the absolute values of the limit values ($U_b$, $-U_b$; $U_c$, $-U_c$) of a further discriminator (7b, 7c) in each case lies [sic] between the analog signal amplitude corresponding to the preceding increment and the analog signal amplitude corresponding to the further increment, and
– the difference discriminator (10) is followed by a logic circuit (13) which in each case passes only the tracking signal corresponding to the highest tracking number of the tracking signals generated by the difference discriminator (10).

7. Analog/digital converter according to claim 6, characterised in that one increment differs from the preceding one in each case by a factor which is an integral power of two.

**Revendications**

1. Convertisseur analogique-numérique comportant un intégrateur numérique (1) un convertisseur numérique-analogique (2) auquel le signal de sortie de l'intégrateur numérique (1) est appliqué, un dispositif amplificateur d'entrée (3) auquel le signal d'entrée analogique est appliqué, un élément soustracteur (5) qui forme un signal de différence à partir du signal de sortie du dispositif amplificateur d'entrée (3) et du signal de sortie du convertisseur numérique-analogique (2) ainsi qu'un circuit d'asservissement (6) qui, en fonction du signal de différence, produit des signaux d'asservissement pour l'intégrateur numérique (1), caractérisé en ce que le facteur d'amplification (A) du dispositif amplificateur d'entrée (3) est piloté en fonction de la valeur de sortie de l'intégrateur numérique (1), qu'avec l'intégrateur numérique (1) est en liaison active un multiplicateur (4) dont la valeur de sortie provoque, en fonction du facteur d'amplification réel (A), un transfert de la valeur de sortie multipliée de l'intégrateur numérique (1) à nouveau dans l'intégrateur numérique (1) et qu'un circuit logique de commande (9) piloté par la sortie de l'intégrateur numérique (1) est prévu pour la conversion de zone et le stockage d'une première configuration binaire de sortie qui représente le facteur d'amplificateur réel, ce dernier facteur formant avec la valeur de sortie de l'intégrateur numérique (1) l'autre partie de la configuration binaire de sortie, de sorte que les deux configurations binaires forment ensemble la valeur de mesure numérisée.

2. Convertisseur analogique-numérique suivant la revendication 1, caractérisé en ce que le dispositif amplificateur d'entrée peut être commuté entre un premier et au moins un autre facteur d'amplification (A), le ou les autres facteurs d'amplification étant plus petits que le premier, que le circuit logique de commande (9) est agencé d'une manière telle que, lorsque la valeur de sortie de l'intégrateur numérique (1) dépasse par excès une valeur limite positive (S$^+$) ou par défaut une valeur limite négative (S$^-$), il provoque une commutation sur un facteur d'amplification plus petit et, simultanément se produit une multiplication de la valeur de sortie de l'intégrateur numérique (1) par un facteur qui correspond au quotient (9) du facteur d'amplification réel, auquel s'est produite la commutation, et le facteur d'amplification précédemment valide, et le circuit logique de commande (9) provoque une nouvelle commutation de la valeur d'entrée vers un facteur d'amplification plus grand lorsque cette commutation aboutit à une valeur de sortie de l'intégrateur numérique (1) qui se situe entre lesdites valeurs limites (S$^+$, S$^-$).

3. Convertisseur analogique-numérique suivant la revendication 1 ou 2, caractérisé en ce que le circuit logique de commande (9) provoque une commutation sur un facteur d'amplification supérieur lorsque la valeur de sortie (S$_1$) de l'intégrateur numérique (1) indique la valeur zéro.

4. Convertisseur analogique-numérique suivant la revendication 1, 2 ou 3, caractérisé en ce que divers facteurs d'amplification se différent chacun d'un facteur qui est une puissance entière de deux.

5. Convertisseur analogique-numérique suivant la revendication 4, caractérisé en ce que l'intégrateur numérique (1) a la forme d'un compteur progressif/régressif forçable et qu'en vue de changements de son signal de sortie (S$_1$) lors de commutations d'un facteur d'amplification à un autre, qui diffère des autres par un facteur $2^{-n}$, chaque bit en dehors du bit le plus significatif est amené à partir de la sortie de l'intégrateur numérique (1), le cas échéant à une entrée de forçage en vue du forçage d'un autre bit dont le poids diffère chaque fois d'un facteur $2^{-n}$ de celui du premier.

6. Convertisseur analogique-numérique suivant l'une quelconque des revendications 1 à 5, caractérisé en ce que son circuit d'asservissement (6) contient un discriminateur multifenêtre (10) comportant

- un premier discriminateur (11) qui compare le signal de différence à une première valeur limite supérieure positive (U$_a$) et à une première valeur limite inférieure négative (-U$_a$), dont la valeur absolue se situe entre zéro et la grandeur du signal analogique sur la sortie du convertisseur numérique-analogique (2) correspondant à un bit le moins significatif sur la sortie de l'intégrateur numérique (1), et
- lors d'un dépassement par excès de la première valeur limite supérieure (U$_a$) et par défaut de la première valeur limite inférieure (-U$_a$), un signal d'asservissement correspondant est chaque fois produit pour augmenter ou diminuer le nombre présent sur la sortie de l'intégrateur numérique (1) d'un premier incrément qui a la valeur du bit le moins significatif, que le discriminateur de différence (10)
- contient au moins un autre discriminateur (11b, 11c) qui compare le signal de différence à une autre valeur limite supérieure (U$_b$, U$_c$) et à une autre valeur limite inférieure (-U$_b$, -U$_c$), et
- lors d'un dépassement par excès de l'autre valeur limite supérieure (U$_b$, U$_c$) et par défaut de l'autre valeur limite inférieure (-U$_b$, -U$_c$), un signal d'asservissement correspondant est chaque fois produit pour augmenter ou diminuer le nombre présent sur la sortie de l'intégrateur numérique (1) d'un autre incrément, étant entendu que

- l'autre incrément est chaque fois supérieur à l'incrément précédent,
- la valeur absolue de la valeur limite (U$_b$, -U$_b$; U$_c$, -U$_c$) d'un autre discriminateur (7b, 7c) se situe chaque fois entre la grandeur du signal analogique correspondant à l'incrément précédent, et la grandeur du signal analogique correspondant à l'autre incrément, et
- le discriminateur de différence (10) est suivi d'un circuit-logique (13) qui ne laisse chaque fois passer que celui des signaux d'asservissement produits par le discriminateur de différence qui corresponduor au nombre d'asservissement le plus haut.

7. Convertisseur analogique-numérique suivant la revendication 6, caractérisé en ce qu'un incrément diffère chaque fois d'un incrément précédent par un facteur qui est une puissance entière de deux.

IN

3

5

2 D/A

6

13

1

Load

4

4, ¼

9

B

B'

A

OUT

FIG. 1

FIG.2

FIG. 3

FIG. 4

FIG. 5

FIG. 6